# EUROPÄISCHE PATENTSCHRIFT

(11) **EP 0 361 029 B1**
(45) Veröffentlichungstag und Bekanntmachung des Hinweises auf die Patenterteilung: **19.05.1993**
(21) Anmeldenummer: 89114378.6
(22) Anmeldetag: 03.08.1989
(51) Int. Cl.: C25D 17/00, C25D 17/28

(54) **Galvanisiereinrichtung für plattenförmige Werkstücke, insbesondere Leiterplatten**
Electroplating apparatus for planar work pieces, particularly circuit boards
Appareil pour le revêtement électrolytique de pièces en forme de plaque, notamment de cartes de circuits imprimés

(30) Priorität: 01.09.1988 DE 3829762
(43) Veröffentlichungstag der Anmeldung: 04.04.1990
(73) Patentinhaber: Siemens Nixdorf Informationssysteme Aktiengesellschaft, 33102 Paderborn (DE)
(72) Erfinder: Hosten, Daniel, B-8120 Handzame (Kortemark) (BE)
(74) Vertreter: Fuchs, Franz-Josef, Dr.-Ing.

(56) Entgegenhaltungen:
- EP-A- 0 254 962
- EP-A- 0 362 512
- DE-A- 3 236 545
- DE-A- 3 624 481
- GB-A- 1 482 958

## Beschreibung

Die Erfindung betrifft eine Galvanisiereinrichtung für im horizontalen Durchlauf zum Auftrag eines Metalles durch eine Elektrolytlösung geführte plattenförmige Werkstücke, insbesondere Leiterplatten.

Eine derartige Galvanisiereinrichtung ist aus der DE-A-32 36 545 bekannt. Bei der dort beschriebenen Einrichtung werden die plattenförmigen Werkstücke horizontal durch die Elektrolytlösung geführt. Der Vorschub der Werkstücke erfolgt über angetriebene Kontakträder, die auf einer Seite in der Behandlungszelle angeordnet sind und gleichzeitig auch als Kontaktiervorrichtung zur kathodischen Kontaktierung der Werkstücke dienen. Zum Schutz der Kontrakträder vor der Elektrolytlösung sind sich in Durchlaufrichtung erstreckende Abschirmungen mit an dem jeweiligen Werkstück anliegenden Dichtleisten vorgesehen. Auf der den Kontakträdern gegenüberliegenden Seite der Behandlungszelle ist zur Führung und Halterung der Werkstücke eine besondere Gleitbefestigung angeordnet.

Bei der vorstehend geschilderten Galvanisiereinrichtung kann auch die Verwendung der Dichtleisten den Zutritt von Elektrolytlösung zu seitlichen Kontaktierungsbereich der Werkstücke und zu den Kontakträdern nicht in einem ausreichenden Umfang verhindern. Als Folge dieser unvollständigen Abdichtungen kommt es zu schwammigen Metallabscheidungen im Kontaktbereich, zu einer rapiden Verschlechterung der Rollkontakte und zu ungünstigen Schichtdickenverteilungen der galvanisch abgeschiedenen Metallschichten bzw. zu einer starken Streuung der Schichtdicke.

Aus der DE-A-36 24 481 ist eine Galvanisiereinrichtung bekannt, bei welcher die Transporteinrichtung als eine endlos umlaufende, angetriebene Reihe einzelner Transportorgane ausgebildet ist, welche die Seitenränder der plattenförmigen Werkstücke festhalten und in der Transportrichtung bewegen, wobei zu Beginn und Ende des in der Elektrolysekammer gelegenen Transportweges der plattenförmigen Werkstücke Mittel vorgesehen sind, die ein Erfassen der plattenförmigen Werkstücke durch die Transportorgane, bzw. das Freigeben der plattenförmigen Werkstücke durch die Transportorgane bewirken. Dabei ist - abgesehen vom Beginn des Ergreifens bzw. Beginn des Freigebens - keine Relativbewegung zwischen den Transportorganen und den Werkstücksrändern gegeben, so daß Abnützungserscheinungen bzw. Abriebserscheinungen der Transportorgane vermieden werden. Die Transportorgane können dann auch zugleich der Stromzuführung zu den plattenförmigen Werkstücken dienen.

Aus der EP-A-0 254 962 ist eine weitere gattungsgemäße Galvanisiereinrichtung bekannt, bei welcher die Kontaktiervorrichtung durch seitlich mit dem Werkstück verfahrbare zangenförmige Kontaktklemmen gebildet ist, wobei vorzugsweise ein endloser Trieb als verfahrbarer Träger der Kontaktklemmen dient. Die Kontaktklemmen können dabei auch gleichzeitig als Transportorgane für den Durchlauf der Werkstücke dienen. Durch eine seitlich sich in Durchlaufrichtung erstreckende und am jeweiligen Werkstück federnd anliegende Dichtung werden die Kontaktklemmen vor dem Zutritt von Elektrolytlösung abgeschirmt.

Der Erfindung liegt die Aufgabe zugrunde bei einer gattungsgemäßen Galvanisiereinrichtung die Abschirmung der Kontaktiervorrichtung vor dem Zutritt von Elektrolytlösung weiter zu verbessern und damit eine bessere kathodische Kontaktierung der Werkstücke zu gewährleisten.

Zur Lösung dieser Aufgabe ist eine Galvanisiereinrichtung vor gesehen mit
- mindestens einer seitlich der Durchlaufbahn angeordneten, aus oberem Bandtrieb und unterem Bandtrieb bestehenden Transporteinrichtung für die reibschlüssige Mitnahme der Werkstücke zwischen dem unteren Trum des oberen Bandtriebes und dem oberen Trum des unteren Bandtriebes,
- mindestens einer seitlich der Durchlaufbahn angeordneten Kontaktiervorrichtung zur kathodischen Kontaktierung des über die Bandtriebe überstehenden Seitenrandes der Werkstücke und mit
- jeweils einer zwischen oberem Trum und unterem Trum der Bandtriebe angeordneten Dichtwand zur seitlichen Abschirmung der Kontaktiervorrichtung vor dem Zutritt von Elektrolytlösung.

Die seitliche Abschirmung der Kontaktiervorrichtung wird also durch fest gegen die Oberfläche der Werkstücke gdrückte Abdichtbänder vorgenommen, wobei diese Abdichtbänder gleichzeitig als Transportorgane die reibschlüssige Mitnahme der Werkstücke bewirken. Bei besonders geringem baulichen Aufwand wird also eine sehr gute seitliche Abschirmung der Kontaktiervorrichtung vor dem Zutritt von Elektrolytlösung erreicht. Außerdem ist auch hier keine Relativbewegung zwischen den Transportorganen und den Werkstücksbändern gegeben, d. h. Abnützungserscheinungen der Transportorgane werden vermieden.

Gemäß einer bevorzugten Ausgestaltung der Erfindung ist zu beiden Seiten der Durchlaufbahn jeweils mindestens eine Transporteinrichtung angeordnet, wodurch eine besonders sichere Führung der Werkstücke erzielt wird. Da sich in diesem Fall eine beidseitige Abschirmung bzw. Abdichtung ergibt, kann dann zur weiteren Verbesserung der kathodischen Kontaktierung zu beiden Seiten der Durchlaufbahn jeweils mindestns eine Kontaktiervorrichtung angeordnet werden.

Durch die effektive Abschirmung des Kontaktierungsbereichs kann dann auch eine ortsfest angeordnete Kontaktiervorrichtung zur Schleifkontaktierung der Werkstücke verwendet werden. Eine besonders hochwertige kathodische Kontaktierung wird in diesem Fall dann erzielt, wenn die Kontaktiervorrichtung mehrere im Abstand zueinander angeordnete Kontaktfederpaare aufweist, deren einander gegenüberliegende Kontaktfedern federnd an der Oberseite und der Unterseite der Werkstücke anliegen.

Gemäß einer Variante kann jedoch auch eine Kontaktiervorrichtung mit synchron mit den Werkstücken mitlaufenden Kontaktmitteln vorgesehen sein. Die bei der Schleifkontaktierung vorhandene Relativbewegung zwischen Werkstück und Kontaktmitteln entfällt also in diesem Fall. Die Kontaktmittel sind dann vorzugsweise auf einem endlosen Trieb angeordnet, der mit der Transporteinrichtung leicht synchronisiert werden kann.

Gemäß einer ersten Ausführungsform können dann die Kontaktmittel durch eine endlos umlaufende, bandförmige Bürstenanordnung gebildet sein. Gemäß einer zweiten bevorzugten Ausführungsform ist vorgesehen, daß die Kontatkmittel durch mehrere im Abstand zueinander an einem endlos umlaufenden Metallband befestigte Kontaktfederpaare gebildet sind, deren einander gegenüberliegende Kontaktfedern federnd an der Oberseite und der Unterseite der Werkstücke anliegen. In beiden Fällen kann dann im Bereich des rücklaufenden Trums des endlosen Triebes eine Reinigungs-Einrichtung zur Reinigung der umlaufenden Kontaktmittel angeordnet werden. Die Reinigungs-Einrichtung, die vorzugsweise durch eine elektrolytische Endmetallisierungszelle gebildet ist, bewirkt dann eine Steigerung der Kontaktfähigkeit und insbesondere auch eine Entfernung eventuell auf den Kontaktmitteln erfolgter Metallabscheidungen.

Ausführungsbeispiele der Erfindung sind in der Zeichnung dargestellt und werden im folgenden näher beschrieben.

Es zeigen
- Fig. 1: das Prinzip einer aus oberem und unterem Bandtrieb bestehenden erfindungsgemäßen Transport- und Abdichteinrichtung,
- Fig. 2: und Fig. 3 zwei verschiedene Querschnitte durch eine Galvanisiereinrichtung mit der Transport- und Abdichteinrichtung gemäß Fig. 1,
- Fig. 4: eine perspektivische, teilweise aufgebrochene Darstellung der in den Fig. 2 und 3 im Querschnitt gezeigten Galvanisiereinrichtung,
- Fig. 5: eine Galvanisiereinrichtung gemäß Fig. 4 jedoch mit einer umlaufenden bandförmigen Bürstenanordnung als Kontaktiervorrichtung und
- Fig. 6: eine weitere Ausführungsform einer mitlaufenden Kontaktiervorrichtung die aus einem Metallband und daran angebrachten Kontaktfederpaaren besteht.

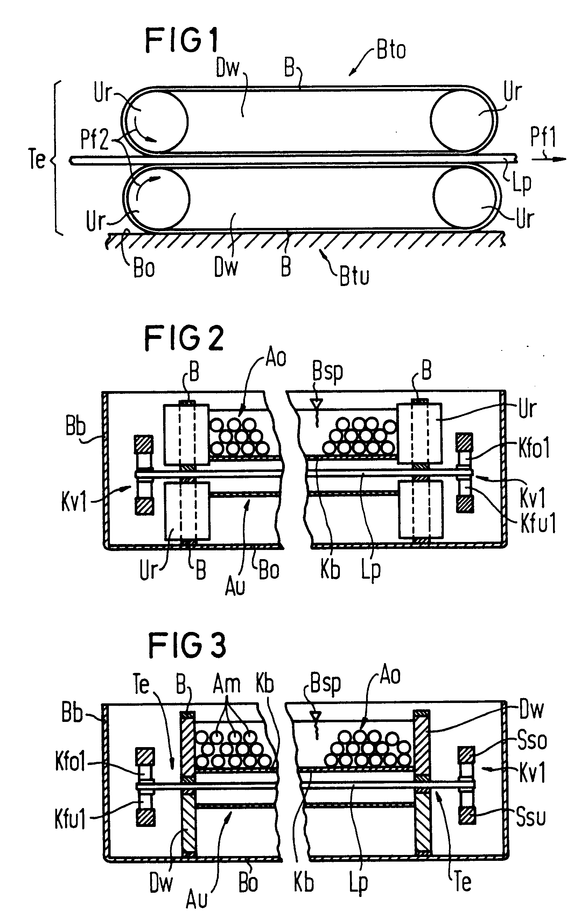

Fig. 1 zeigt in stark vereinfachter schematischer Darstellung die prinzipielle Wirkungsweise einer insgesamt mit Te bezeichneten Transporteinrichtung, welche Leiterplatten Lp in horizontaler Lage in Richtung des Pfeiles Pf1 durch eine nicht näher dargestellte Elektrolytlösung transportiert. Die Transporteinrichtung Te besteht aus einem oberen Bandtrieb Bto und einem unteren Bandtrieb Btu, wobei die beiden Bandtriebe jeweils ein über zwei im Abstand zueinander angeordnete Umlenkrollen Ur endlos umlaufendes Band B aufweisen. Durch einen nicht näher dargestellten Antrieb sind eine obere und eine untere Umlenkrolle Ur derart angetrieben, daß die Leiterplatten Lp in Richtung der Pfeile Pf2 zwischen die Bandtriebe Bto und Btu eingezogen und zwischen dem horizontalen unteren Trum des oberen Bandtriebes Bto und dem horizontalen oberen Trum des unteren Bandtriebes Btu in Richtung des Pfeiles Pf1 mitgenommen werden. Die Bänder B liegen dabei im Seitenbereich der Leiterplatte Lp über die gesamte Länge dicht an der Oberseite und an der Unterseite an, so daß zwischen Band B und Leiterplatte Lp keine Elektrolytlösung hindurchtreten kann. Durch Verwendung von Bändern B auf der Basis besonders elastischer Stoffe wie Gummi und dergleichen kann diese Dichtwirkung zusätzlich noch verstärkt werden. Eine vergleichbare Dichtwirkung ergibt sich dann auch zwischen den Bändern B und Dichtwänden Dw, die jeweils zwischen dem oberen Trum und dem unteren Trum der Bandtriebe Bto und Btu angeordnet sind und auch an den Umlenkrollen Ur dicht anliegen. Liegt dann zusätzlich noch das untere Trum des unteren Bandtriebes Btu dicht am Boden Bo eines die Elektrolytlösung enthaltenden Behälters an, so bilden der obere Bandtrieb Bto und der untere Bandtrieb Btu in Verbindung mit den Dichtwänden Dw eine Abschirmung, welche den seitlichen Austritt von Elektrolytlösung zumindest weitgehend verhindert. Anstelle der Umlenkrollen Ur können für die stirnseitige Abdichtung auch Stirnwände verwendet werden, die für den Durchtritt der Leiterplatten Lp und der Bänder B mit entsprechenden Schlitzen versehen sind. Als Bauteile der Transporteinrichtung Te sind auch in diesem Fall die Umlenkrollen Ur jedoch noch nach wie vor vorhanden.

Die Fig. 2 und 3 zeigen in einem Schnitt vor den Umlenkrollen Ur bzw. in einem Schnitt zwischen den Umlenkrollen Ur den Einbau von insgesamt zwei Transporteinrichtungen Te gemäß Fig.1 in den Badbehälter Bb einer Galvanisiereinrichtung. Der Badspiegel der im Badbehälter Bb enthaltenen Elektrolytlösung ist dabei mit Bsp bezeichnet. Es ist ferner zu erkennen, daß sich im geringen Abstand oberhalb der Durchlaufbahn der Leiterplatten Lp eine horizontal ausgerichtete obere Anode Ao befindet, die aus einem Korb Kb aus Streckmetall und kugelförmigem Anodenmaterial Am besteht. Im geringen Abstand unter der Durchlaufbahn der Leiterplatten Lp ist eine ebenfalls horizontal ausgerichtete untere Anode Au angeordnet, die als Steckmetallsieb ausgebildet ist und beispielsweise aus platiniertem Titan besteht. Im Gegensatz zur oberen Anode Ao, die beispielsweise Kupferkugeln als Anodenmaterial Am enthält, handelt es sich bei der unteren Anode Au also um eine unlösliche Anode.

Die kathodische Kontaktierung der Leiterplatten Lp erfolgt über beidseitig der Durchlaufbahn angeordnete Kontaktiervorrichtungen Kv1, welche die über die ebenfalls beidseitig angeordneten Transporteinrichtungen Te überstehenden Seitenränder der Leiterplatten Lp erfassen. Jede der beiden Kontaktiervorrichtungen Kv1 besteht dabei aus einer oberen Stromschiene Sso, die mehrere im Abstand zueinander angeordnete obere Kontaktfedern Kfo1 trägt und aus einer unteren Stromschiene Ssu, die mehrere im Abstand zueinander angeordnete untere Kontaktfedern Kfu1 trägt. Die paarweise einander gegenüberliegenden oberen Kontaktfedern Kfo1 und unteren Kontaktfedern Kfu1 ermöglichen dabei eine zuverlässige Schleifkontaktierung der Leiterplatten Lp.

Insbesondere aus dem in Fig. 3 gezeigten Querschnitt ist ohne weiteres ersichtlich, daß die beiden Transporteinrichtungen Te in Verbindung mit den Dichtwänden Dw auch die Funktion einer Dichteinrichtung erfüllen, welche die Kontaktiervorrichtungen Kv1 vor Beeinträchtigungen durch den Zutritt von Elektrolytlösung schützen.

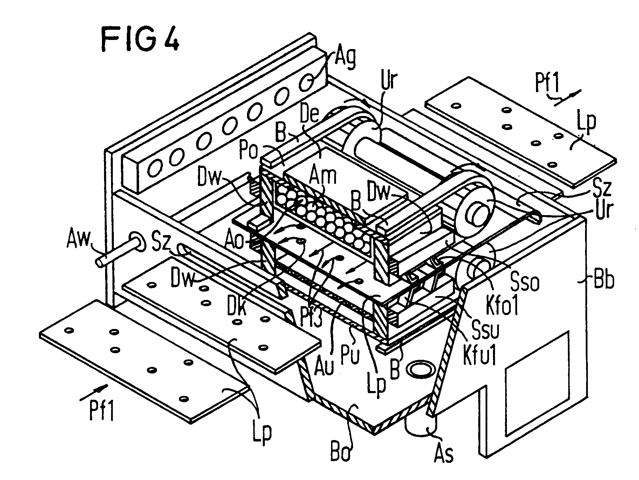

Fig. 4 zeigt eine perspektivische Darstellung der in den Fig. 2 und 3 in verschiedenen Querschnitten dargestellten Galvanisiereinrichtung. Es ist zu erkennen, daß die beiden Stirnwände des Badbehälters Bb in Höhe der durch die Pfeile Pf1 aufgezeigten Durchlaufbahn mit horizontalen Schlitzen Sz versehen sind, die den Durchtritt der Leiterplatten Lp ermöglichen. Der Innenraum zwischen einer in Fig. 4 nicht dargestellten oberen Abschlußhaube und dem Badbehälter Bb ist auf einer Seite mit einer Absaugung Ag versehen, die zur Erzeugung eines Unterdrucks in diesem Raum an eine zentrale Absaugeinrichtung angeschlossen ist. Unterhalb der Absaugung Ag ist eine in Längsrichtung verlaufende Antriebswelle Aw zu erkennen, welche die beiden dargestellten oberen Umlenkrollen Ur über nicht näher erkennbare Kegelräder antreibt.

Die in Fig. 4 nicht dargestellte seitliche Zufuhr von Elektrolytlösung in den Badbehälter Bb und der Ablauf über einen in den Boden Bo eingebrachten Ablaufstutzen As sind so bemessen, daß durch die Durchkontaktierungslöcher Dk der Leiterplatten Lp eine nach oben gerichtete und durch die Pfeile Pf3 aufgezeigte Strömung entsteht. Durch diese ausgeprägte Strömung wird - sofern andere Voraussetzungen erfüllt sind - eine qualitativ hochwertige galvanische Verstärkung der Durchkontaktierungen gewährleistet.

Abweichend von den in den Fig. 2 und 3 gezeigten Querschnitten ist in Fig. 4 eine Alternative aufgezeigt, gemäß der zwischen den beiden oberen Dichtwänden Dw und den beiden oberen Trumen der oberen Bandtriebe Bto (vergleiche Fig. 1) eine horizontal ausgerichtete und sich quer zur Durchlaufrichtung erstreckende obere Platte Po angeordnet ist. Um das Anodenmaterial Am austauschen zu können ist die obere Platte Po mit einer durch eine Deckel De verschließbaren Öffnung versehen. In ähnlicher Weise ist zwischen den unteren Trumen der beiden unteren Bandtriebe Btu (vergleiche Fig. 1) und den unteren Dichtwänden Dw eine sich ebenfalls quer zur Durchlaufrichtung erstreckende untere Platte Pu angeordnet.

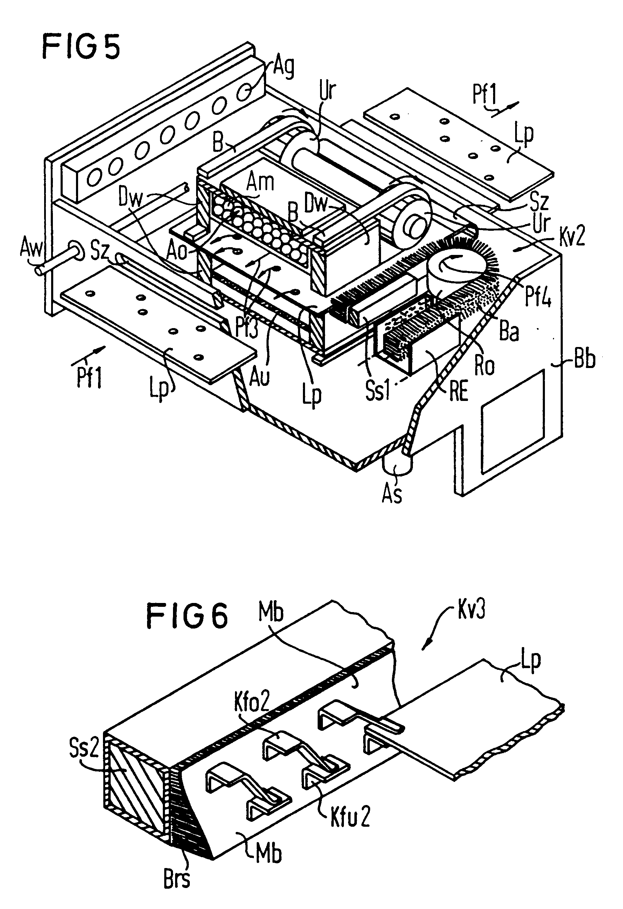

Fig. 5 zeigt eine Variante der in Fig. 4 dargestellten Galvanisiereinrichtung, bei welcher anstelle der Kontaktiervorrichtung Kv1 eine Kontaktiervorrichtung Kv2 mit einer endlos umlaufenden, bandförmigen Bürstenanordnung Ba vorgesehen ist. Diese Bürstenanordnung Ba läuft über zwei Rollen Ro um, wobei eine Rolle Ro in Richtung des Pfeiles Pf4 derart angetrieben ist, daß die Bürstenanordnung Ba synchron mit den Leiterplatten Lp mitläuft. Die Zufuhr des Kathodenstroms erfolgt über eine ortsfest angeordnete Stromschiene auf die darauf gleitende Bürstenanordnaung Ba und von der Bürstenanordnung Ba auf die jeweilige Leiterplatte Lp.

Sollten sich auf der Bürstenanordnung Ba durch eventuell austretende Elektrolytlösung unerwünschte Metallabscheidungen und Ablagerungen bilden, so werden diese im Bereich des rücklaufenden Trums der Bürstenanordnung Ba durch eine Reinigungs-Einrichtung RE wieder entfernt. Diese Reinigungs-Einrichtung RE ist als elektrolytische Entmetallisierungszelle ausgebildet, die eine Elektrolytlösung, vorzugsweise die für das Galvansieren verwendete Elektrolytlösung, enthält. Die Entmetallisierung erfolgt dann durch eine anodische Kontaktierung der Bürstenanordnung Ba relativ zu einer in der Reinigungs-Einrichtung RE befindlichen Kathode.

Fig. 6 zeigt mit der Kontaktiervorrichtung Kv3 eine weitere Möglichkeit für synchron mit den Leiterplatten Lp mitlaufende Kontaktmittel. Diese Kontaktmittel sind durch mehrere im Abstand zueinander an einem endlos umlaufenden Metallband Mb befestigte Kontaktfederpaare gebildet. Jedes Kontaktfederpaar besteht aus einer oberen Kontaktfeder Kfo2 und einer gegenüberliegenden unteren Kontaktfeder Kfu2, welche die Seitenränder der Leiterplatten Lp unter Aufrechterhaltung eines gewissen federnden Kontaktdruckes zwischen sich aufnehmen. Die Stromzufuhr zu dem Metallband Mb erfolgt über eine rückseitig ortsfest angeordnete Stromschiene Ss2 und Bürsten Brs. Die Stromschiene Ss2 ist vorzugsweise durch einen titanummantelten massiven Kupferleiter gebildet. Die Bürsten Brs bestehen vorzugsweise aus Kupfer, während sich für das Metallband Mb und die Kontaktfedern Kfo2 und Kfu2 Titan als Werkstoff sehr gut bewährt hat. Eine Reinigung bzw. Entmetallisierung der Kontaktfedern Kfo2 und Kfu2 ist auch hier nach dem in Fig. 5 dargestellten Prinzip möglich.

## Patentansprüche

1. Galvanisiereinrichtung fur im horizontalen Durchlauf zum Auftrag eines Metalles durch eine Elektrolytlösung geführte plattenförmige Werkstücke, insbesondere Leiterplatten, mit
- mindestens einer seitlich der Durchlaufbahn angeordneten, aus oberem Bandtrieb (Bto) und unterem Bandtrieb (Btu) bestehenden Transporteinrichtung (Te) für die reibschlussige Mitnahme der Werkstucke zwischen dem unteren Trum des oberen Bandtriebes (Bto) und dem oberen Trum des unteren Bandtriebes (Btu),
- mindestens einer seitlich der Durchlaufbahn angeordneten Kontaktiervorrichtung (Kv1,Kv2,Kv4) zur kathodischen Kontaktierung des über die Bandtriebe (Bto,Btu) überstehenden Seitenrandes der Werkstücke und mit
- jeweils einer zwischen oberem Trum und unterem Trum der Bandtriebe (Bto,Btu) angeordneten Dichtwand (Dw) zur seitlichen Abschirmung der Kontaktiervorrichtung (Kv1,Kv2,Kv3) vor dem Zutritt von Elektrolytlösung.

2. Galvanisiereinrichtung nach Anspruch 1,
**dadurch gekennzeichnet,**
daß zu beiden Seiten der Durchlaufbahn jeweils mindestens eine Transporteinrichtung (Te) angeordnet ist.

3. Galvanisiereinrichtung nach Anspruch 2,
**dadurch gekennzeichnet,**
daß zu beiden Seiten der Durchlaufbahn jeweils mindestens eine Kontaktiervorrichtung (Kv1, Kv2, Kv3) angeordnet ist.

4. Galvanisiereinrichtung nach einem der vorhergehenden Ansprüche,
**gekennzeichnet durch**
eine ortsfest angeordnete Kontaktiervorrichtung (Kv1) zur Schleifkontaktierung der Werkstücke.

5. Galvanisiereinrichtung nach Anspruch 4,
**dadurch gekennzeichnet,**
daß die Kontaktiervorrichtung (Kv1) mehrere im Abstand zueinander angeordnete Kontaktfederpaare aufweist, deren einander gegenüberliegende Kontaktfedern (Kfo1,Kfu1) federnd an der Oberseite und der Unterseite der Werkstücke anliegen.

6. Galvanisiereinrichtung nach einem der Ansprüche 1 bis 3,
**gekennzeichnet durch**
eine Kontaktiervorrichtung (Kv2,Kv3) mit synchron mit den Werkstücken mitlaufenden Kontaktmitteln.

7. Galvanisiereinrichtung nach Anspruch 6,
**dadurch gekennzeichnet,**
daß die Kontaktmittel auf einem endlosen Trieb angeordnet sind.

8. Galvanisiereinrichtung nach Anspruch 7,
**dadurch gekennzeichnet,**
daß die Kontaktmittel durch eine endlos umlaufende, bandförmige Bürstenanordnung (Ba) gebildet sind.

9. Galvanisiereinrichtung nach Anspruch 7,
**dadurch gekennzeichnet,**
daß die Kontaktmittel durch mehrere im Abstand zueinander an einem endlos umlaufenden Metallband (Mb) befestigte Kontaktfederpaare gebildet sind, deren einander gegenüberliegende Kontaktfedern (Kfo2,Kfu2) federnd an der Oberseite und der Unterseite der Werkstücke anliegen.

10. Galvanisiereinrichtung nach einem der Ansprüche 7 bis 9,
**dadurch gekennzeichnet,**
daß im Bereich des rücklaufenden Trums des endlosen Triebes eine Reinigungs-Einrichtung (RE) zur Reinigung der umlaufenden Kontaktmittel angeordnet ist.

11. Galvanisiereinrichtung nach Anspruch 10,
**dadurch gekennzeichnet,**
daß die Reinigungs-Einrichtung (RE) durch eine elektrolytische Entmetallisierungszelle gebildet ist.

## Claims

1. Electroplating apparatus for panel-type workpieces, in particular printed circuit boards, which are passed horizontally through an electrolyte solution in order to apply a metal, comprising
- at least one conveyor device (Te) which is disposed at the side of the conveyance path and comprises an upper belt drive (Bto) and a lower belt drive (Btu) for the frictionally induced entrainment of the workpieces between the lower run of the upper belt drive (Bto) and the upper run of the lower belt drive (Btu),
- at least one connection device (Kv1, Kv2, Kv4) disposed at the side of the conveyance path for cathodically connecting the side edge of the workpieces which projects beyond the belt drives (Bto, Btu), and
- one sealing wall (Dw) in each case disposed between the upper run and the lower run of the belt drives (Bto, Btu) to laterally screen the connecting device (Kv1, Kv2, Kv3) from the access of electrolyte solution.

2. Electroplating apparatus according to Claim 1, characterised in that in each case at least one conveyor device (Te) is disposed on either side of the conveyance path.

3. Electroplating apparatus according to Claim 2, characterised in that at least one connection device (Kv1, Kv2, Kv3) in each case is disposed on either side of the conveyance path.

4. Electroplating apparatus according to one of the preceding claims, characterised by a fixed connection device (Kv1) for making a sliding connection to the workpieces.

5. Electroplating apparatus according to Claim 4, characterised in that the connection device (Kv1) comprises a plurality of contact spring pairs which are arranged at a distance from one another and whose oppositely situated contact springs (Kfo1, Kfu1) are in resilient contact with the top and bottom of the workpieces.

6. Electroplating apparatus according to one of Claims 1 to 3, characterised by a connection device (Kv2, Kv3) having contact means running synchronously and concomitantly with the workpieces.

7. Electroplating apparatus according to Claim 6, characterised in that the contact means are disposed on an endless drive.

8. Electroplating apparatus according to Claim 7, characterised in that the contact means are formed by an endlessly circulating, belt-type brush arrangement (Ba).

9. Electroplating apparatus according to Claim 7, characterised in that the contact means are formed by a plurality of contact spring pairs which are mounted at a distance from one another on an endlessly circulating metal belt (Mb) and whose oppositely situated contact springs (Kfo2, Kfu2) are in resilient contact with the top and bottom of the workpieces.

10. Electroplating apparatus according to one of Claims 7 to 9, characterised in that, in the region of the return run of the endless drive, a cleaning device (RE) is provided for cleaning the circulating contact means.

11. Electroplating device according to Claim 10, characterised in that the cleaning device (RE) is formed by an electrolytic demetallisation cell.

## Revendications

1. Installation de galvanisation pour des pièces en forme de plaques, notamment des plaquettes de circuits imprimés, passant horizontalement, pour le dépôt d'un métal, à travers une solution électrolytique, comportant
- au moins un dispositif de transport (Te) qui est placé sur le côté de la voie de déplacement et qui présente un transporteur à ruban supérieur (Bto) et un transporteur à ruban inférieur (Btu), pour l'entraînement par friction de la pièce à traiter, entre le brin inférieur du transporteur à ruban supérieur (Bto) et le brin supérieur du transporteur à ruban inférieur (Btu),
- au moins un dispositif d'établissement de contacts (Kv1, Kv2, Kv4) disposé sur le côté de la voie de déplacement, pour l'établissement du contact cathodique du bord latéral de la pièce à traiter, qui déborde les transporteurs à ruban (Bto, Btu), et
- respectivement une paroi d'étanchéité (Dw) placée entre le brin supérieur et le brin inférieur des transporteurs à ruban (Bto, Btu), pour le blindage latéral du dispositif d'établissement de contacts (Kv1, Kv2, Kv3) avant l'admission de la solution électrolytique.

2. Installation de galvanisation selon la revendication 1,
caractérisée en ce que
au moins un dispositif de transport (Te) est prévu respectivement des deux côtés de la voie de déplacement.

3. Installation de galvanisation selon la revendication 2,
caractérisée en ce que,
au moins un dispositif d'établissement de contacts (Kv1, Kv2, Kv3) est prévu respectivement des deux côtés de la voie de déplacement.

4. Installation de galvanisation selon l'une des revendications précédentes,
caractérisée par,
un dispositif fixe d'établissement de contacts (Kv1) pour l'établissement de contacts par frottement de la pièce à traiter.

5. Installation de galvanisation selon la revendication 4,
caractérisée en ce que,
le dispositif d'établissement de contacts (Kv1) comporte plusieurs couples de ressorts de contact disposés à distance les uns des autres et dont les ressorts de contact (Kfo1, Kfu1) placés les uns en face des autres, portent élastiquement sur le côté supérieur et le côté inférieur des pièces à traiter.

6. Installation de galvanisation selon l'une des revendications 1 à 3,
caractérisée par,
un dispositif d'établissement de contacts (Kv2, Kv3) comportant des moyens de contact se déplaçant de manière synchrone avec les pièces à traiter.

7. Installation de galvanisation selon la revendication 6,
caractérisée en ce que,
les moyens de contact sont disposés sur un entraînement sans fin.

8. Installation de galvanisation selon la revendication 7,
caractérisée en ce que,
les moyens de contact sont réalisés par un dispositif à brosse (Ba), en forme de bande et à déplacement sans fin.

9. Installation de galvanisation selon la revendication 7,
caractérisée en ce que,
les moyens de contact sont formés de plusieurs couples de ressorts de contact à distance les uns des autres, fixés à une bande de métal (Mb) à déplacement sans fin et dont les ressorts de contact (Kfo2, Kfu2) placés les uns en face des autres, portent élastiquement sur la partie supérieure et la partie inférieure des pièces à traiter.

10. Installation de galvanisation selon l'une des revendications 7 à 9,
caractérisée en ce que,
un dispositif de nettoyage (RE) pour nettoyer les moyens de contact à déplacement sans fin, est placé dans la zone du brin de retour du transporteur sans fin.

11. Installation de galvanisation selon la revendication 10,
caractérisée en ce que,
le dispositif de nettoyage (RE) est réalisé à l'aide d'une cellule de démétallisation électrolytique.
